# EUROPEAN PATENT SPECIFICATION

(11) **EP 0 621 691 B1**
(45) Date of publication and mention of the grant of the patent: **29.12.1997**
(21) Application number: 94201002.6
(22) Date of filing: 13.04.1994
(51) Int. Cl.: H03K 5/15, H03K 19/0175, H03K 19/003, H03K 19/0944

(54) **Complementary-signal BiCMOS line driver with low skew**
BiCMOS Gegentaktleistungstreiber mit geringer Phasenverschiebung
Circuit BiCMOS d'attaque complémentaire de ligne avec faible décalage de phase

(30) Priority: 19.04.1993 US 49742
(43) Date of publication of application: 26.10.1994
(73) Proprietor: Philips Electronics N.V., 5621 BA Eindhoven (NL)
(72) Inventor: Martin, Brian, c/o Int. Octrooibureau B.V., NL-5656 AA Eindhoven (NL)
(74) Representative: Koppen, Jan

(56) References cited:
- EP-A- 0 239 762
- PATENT ABSTRACTS OF JAPAN vol. 9, no. 305 (E-363) (2028) 3 December 1985 & JP-A-60 142 618 (HITACHI SEISAKUSHO K.K.) 27 July 1985
- PATENT ABSTRACTS OF JAPAN vol. 13, no. 235 (E-766) (3583) 30 May 1989 & JP-A-01 039 817 (TOSHIBA CORP) 10 February 1989

## Description

### FIELD OF THE INVENTION

The invention relates to an electronic circuit comprising a BiCMOS driver circuit that includes an input for receiving an input signal; first and second outputs to provide complementary output signals in response to the input signal; and first and second bipolar push-pull stages driving the first and second outputs, respectively.

### BACKGROUND OF THE INVENTION

A major problem in CMOS/BiCMOS IC design is how to drive a large capacitive load (such as a gate array) from a driver with low input capacitance -- i.e., how to make big signals from small ones. Furthermore, it is often convenient to have complementary signal outputs with very low skew in propagation, meaning that the propagation delays for both outputs are substantially the same. This is important in such applications as, for example, generating both clock phases for latches and flip-flops.

The standard CMOS and BiCMOS solution of staging inverters is unsatisfactory due to the propagation delay through each stage and the inherent skew between complementary signals.

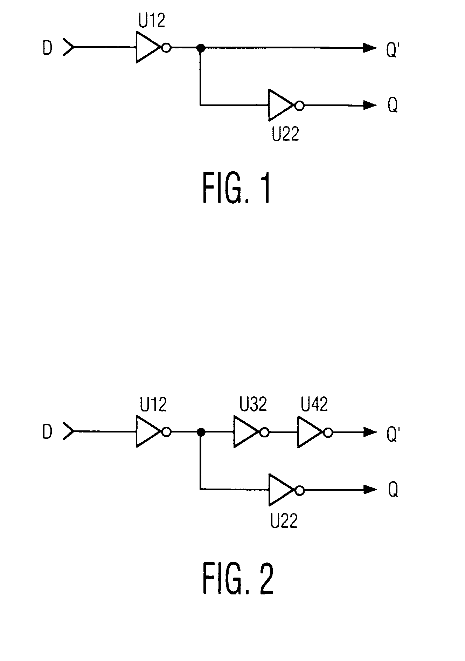

U.S. Patent 4,937,480 shows another approach in its Figure 1 relating to a BiCMOS circuit for translating a single input to two complementary outputs. The BiCMOS circuit is a completely symmetric device. The single input signal is first translated to two voltage levels by a differential amplifier that in turn controls a bistable element. The bistable element has its output nodes connected to respective ones of cross-coupled output circuits that are mutually identical.

European Patent Application 0,239,762 shows a circuit as claimed in the preamble of claim 1.

The differential amplifier in the known circuit always consumes a substantial amount of power, even in a steady state. The faster the switching is to be, the larger the tail current of a differential transistor pair needs to be and, consequently, the larger the steady state power consumption. The translation in the prior art circuit is based on the use of a multitude of different supply voltages VEE, VE1, GND, and a plurality of different reference voltages VBE, VBBC, VBB, VCS2.

Apart from the power consumption due to the differential transistor pairs, the circuit of the prior art has as an additional disadvantage that its operation is determined to a large extent by the accuracy of the supply voltages and the control voltages. Furthermore, the prior art circuit requires extra substrate area to accommodate generators or supply lines for these voltages.

### OBJECT OF THE INVENTION

An object of the invention is to provide a BiCMOS line driver circuit with low input capacitance yet capable of driving large capacitive loads.

Another object of the invention is to provide a BiCMOS circuit with very low skew in propagation.

Another object is to provide such a circuit dispensing with intricate balance and control measures for reference voltages.

### SUMMARY OF THE INVENTION

To this end the invention provides a circuit as specified in the preamble characterized in that the CMOS logic inverters are sized relative to one another as to substantially equalize propagation delays in the signal paths the inverters being sized relative to one another so as to substantially equalize the propagation delays.

The invention is based on the insight that by proper sizing of the CMOS inverter stages, e.g., by selecting the sizes of their transistors, their driving power capabilities are adjusted to compensate for propagation delay differences occurring in the signal paths from the input to the push portions of the bipolar push-pull stages and from the input to the pull portions of the push-pull stages.

As known in the art, a ratio of about 1,7 between the W/L factors of the inverter's PFET and the inverter's NFET is used as a practical optimum. Accordingly, the CMOS inverters used in the invention preferably have this ratio of 1,7 but may have mutually differently sized transistors to account for the required differences in driving power.

The various features of novelty which characterize the invention are pointed out with particularity in the claims annexed to and forming a part of this disclosure. For a better understanding of the invention, its operating advantages and specific objects attained by its use, reference should be had to the accompanying drawings and descriptive matter in which there are illustrated and described the preferred embodiments of the invention by way of example.

### BRIEF DESCRIPTION OF THE DRAWINGS

In the drawings:
Fig. 1 is a block diagram of a conventional driver circuit providing complementary outputs;
Fig. 2 is a block diagram of a another conventional driver circuit providing complementary outputs;
Figs. 3 and 4 are circuit schematics of several forms of line driver circuits according to the invention.

### DETAILED DESCRIPTION OF THE PREFERRED EMBODIMENTS

Figure 1 shows the most obvious method of getting complementary signals in a line driver circuit. The circuit comprises a common input signal D driving an inverter U12, one output of which drives a second inverter U22, whose output is the signal Q, whereas the other output of the inverter U12 is its complement Q'. Regardless of whether U12 and U22 are CMOS or BiCMOS, signal Q trails signal Q' by a propagation delay -- U22 simply can't switch until U12 manages to switch its entire load. The circuit in Figure 2 attempts to eliminate the effects of the load on the Q' signal, but at the expense of slowing it down by the addition of two extra propagation delays through U32 and U42. Although the skew between Q and Q' in Figure 2 may be somewhat less, it still exists and strongly depends on the loading of Q and Q'. In addition, the total propagation delay of the circuit is greater than that of the circuit in Figure 1.

The BiCMOS line driver circuit according to a preferred embodiment of the invention incorporates a fully-powered, zero- static power pull-down driver with a standard BiCMOS pull-up in a novel parallel construction to create a complementary signal driver with very high speed and extremely low skew.

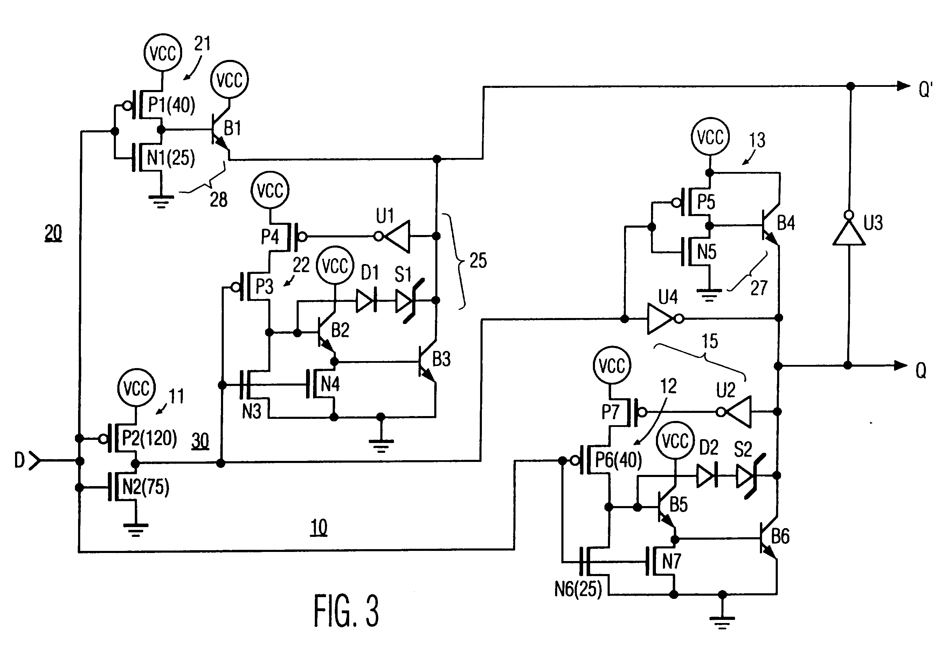

The circuit illustrated in Fig. 3, as one embodiment according to the invention, comprises the following parts: a first input signal path 10 from a common input D leading to an output Q; a second input signal path 20 from the common input D leading to a complementary output Q'; a third input signal path 30 leading from the common input D. As will be explained in more detail below, the direct signal path 10 controls the pull-down for output Q; the direct signal path 20 controls the pull-up for output Q'; and the inverted signal path 30 controls the pull-up for output Q and the pull-down for output Q'. In this circuit and the one following, the following notation is used. Crossing lines do not form connections at their crossing, except where a line passes through the gate of a FET or the base of a bipolar device. A PFET is indicated with a circle at its gate and an NFET without this circle.

Typical CMOS inverters are shown at 11, 21, 12, 13, and 22. It is assumed that a value close to Vcc is a logic-high signal and a value close to ground (Grd) is a logic-low signal. In a typical application, with the input high, the Q and Q' outputs would be connected to separate lines, held normally at a logic-high and logic-low level, respectively. When the input signal D goes low, the Q output should be pulled low and the Q' output pulled high. When the input signal D goes high, the Q output should be pulled high and the Q' output pulled low.

The circuits designated 15 and 25 are each representative of a fully-powered, zero-static power pull-down driver as described below. In circuits 15 and 25, means are provided for channelling current from a DC power source Vcc to the base electrode of a bipolar transistor B6 and B3, respectively, which can therefore pull the circuit's output all the way down to a voltage substantially equal to the collector-emitter saturation voltage V_{SAT} above a reference value, typically ground. In addition, feedback means U2, P7 and U1, P4, respectively, to turn-off the pull-down circuit in response to a full high-to-low transmission at the circuit's output in order to achieve zero-static power. A preferred embodiment employs a Darlington structure in the pull-down circuit for rapid turn-on and to ensure that the output is pulled all the way down to a V_{SAT}.

PFET P7/P4 provides the channelled current from Vcc under control of the inverter U2/U1 which provides the feedback to turn off P7/P4 when the output Q/Q' has fallen down close to Grd. Bipolar transistors B5, B6, and B2, B3 provide the high-gain Darlington circuits for rapid pull-down. PN junction diodes D2/D1 and Schottky diodes S2/S1 help keep transistors B5/B2 and B6/B3 from saturating by draining the bases of B5/B2 when the output voltage falls below 0.2 volts thereby disabling the base drive of transistors B6/B3. The circuits designated 27 and 28 provide standard BiCMOS pull-up circuitry for, respectively, the outputs Q and Q'.

In operation, the input signal D is transmitted down three parallel input signal paths 10, 20 and 30. P1 and N1 control the BiCMOS pull-up for Q', and P6 and N6 control the pull-down for Q. P2 and N2 invert the input signal and apply it to the BiCMOS pull-up 27 for Q and the pull-down 25 for Q'. U3 and U4 form small CMOS "keepers" to hold Q and Q' all the way to Vcc or Gnd.

When receiving the signal D directly from an input, the sizing ratios (width-to-length of a FET channel) of P1 to N1 and P2 to N2 and P6 to N6 must all be equal in order to guarantee a single common threshold or switching voltage at the input. As an example only, which is not to be considered limiting, next to certain of the components in Fig. 3 are numbers in parentheses indicating the FET's width-to-length ratio as an example of suitable sizing ratios. Those skilled in the art will recognize that other sizing ratios within the principles taught herein will also be capable of achieving the benefits described.

There are several advantages to this architecture. First, the parallel input construction allows the designer to designate "slow" and "fast" paths by properly sizing the three input inverters 11, 12 and 21, without having to modify optimum designs for the other components, the goal being that the overall propagation delay in each of the three signal paths is approximately the same. For low skew, the centre path 30 would need to be "fast" to overcome the extra propagation delay; therefore, the P2/N2 inverter would be much larger than the P1/N1 and P6/N6 inverters, typically about 2 or more times larger. An example of suitable sizing ratios would be the following: P1/N1 = P2/N2 = P6/N6 = 8/5, for a mid-range input threshold, and the ratios of P1/P2 = P6/P2 = about 1/3 for low skew. But it will be understood that the circuit of the invention is not limited to having a common input threshold for all three input signal paths. Second, the complementary signals are both generated with a minimum number of propagation delays. Third, the use of the BiCMOS pull-up 27,28 and especially the fully-powered, zero-static power pull-down driver 15,25 create extremely high gain for driving large loads. Further, the large gain tends to make the skew between the Q and the Q' signals relatively independent of their respective loads.

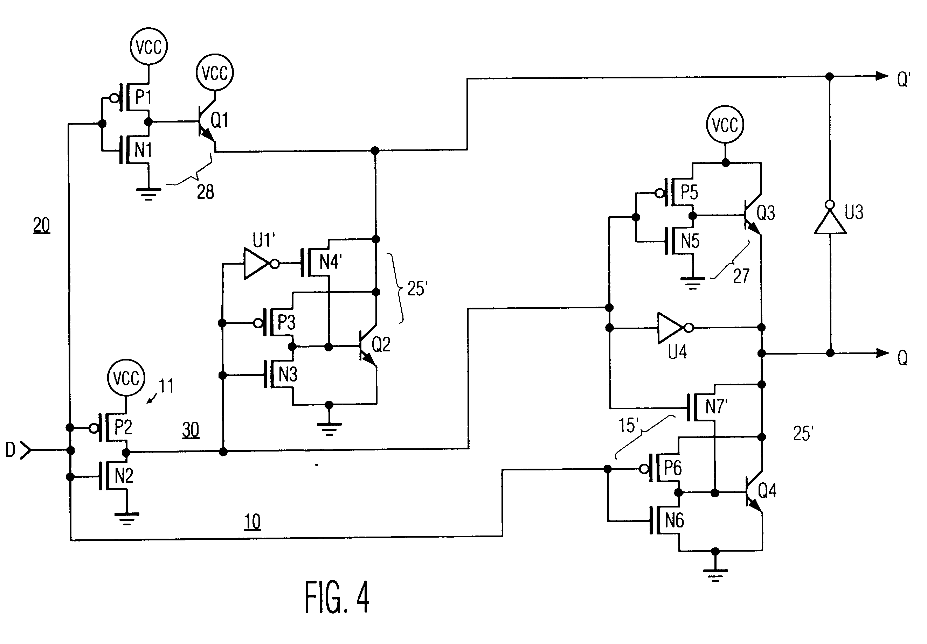

Fig. 4 shows a variant of the Fig. 3 circuit. Elements designated by the same reference numerals function similarly. As before, three parallel input signal paths 10, 20, 30 are created. Path 10 includes a pull-down circuit 15' for the Q output; path 20 includes a pull-up circuit 28 for the Q' output; path 30 includes a pull-up circuit 27 for the Q output and a pull-down circuit 25' for the Q' output. One can still achieve excellent low-skew characteristics from this variant, but the gain is not quite as high, as BiCMOS pull-down circuits 15' and 25' are used instead of their high-gain counterparts in the Fig. 3 circuit.

The pull-down circuit 15' operates as follows. When the D input goes low, PFET P6 turns on quickly for good speed, but its dnve turns off rapidly as the output makes the high-low transition because of the decreasing V_{gs,} and therefore won't guarantee pull-down below 1 volt. NFET N7' turns on after a propagation delay through P2/N2 but provides an active pull-down all the way down to 0.7 volts. The circuit 25' operates similarly with inverter U1' added to provide the correct polarity.

It should be noted that here, as in Fig. 3 also, instead of simple inverters 11, 12 or 21 from the input, additional CMOS logic, e.g., NANDs or NORs, could be added to perform additional functions, and the input logic appropriately sized to take into account the additional propagation delay.

The circuit of the invention is useful for driving other on-chip circuits, as well as an output driver for, for example, busses.

## Claims

1. An electronic circuit comprising a BiCMOS driver circuit that includes:
- an input (D) for receiving an input signal;
- first and second outputs (Q',Q) to provide complementary output signals in response to the input signal;
- first and second bipolar push-pull stages (B1, B3; B4, B6) driving the first and second outputs, respectively;
- a plurality of CMOS inverter stages (11, 12, 13, 21, 22) arranged in a multitude of signals paths (10, 20, 30) from the input to the push-pull stages to control the push-pull stages, characterized in that the CMOS inverter stages (11, 12, 13, 21, 22) are sized relative to one another as to substantially equalize propagation delays in the signal paths.

2. The circuit of claim 1, wherein:
- the first push-pull stage comprises:
- a first push stage with a first bipolar transistor (B1; Q1) and a first pull stage with a second bipolar transistor (B3; Q2), wherein the first and second bipolar transistors have their respective collector-emitter paths interconnected via the first output (Q') and arranged in series between a supply voltage node (Vcc) and ground;
- the second push-pull stage comprises:
- a second push stage with a third bipolar transistor (B4;Q3) and a second pull stage with a fourth bipolar transistor (B6;Q4), wherein the third and fourth bipolar transistors have their respective collector-emitter paths interconnected via the second output (Q) and arranged in series between the supply voltage node and ground;
- the multitude of signal paths comprise:
- a first path (20) to the first push stage;
- a second path (30) to the first pull stage;
- a third path (30) to the second push stage;
- a fourth path (10) to the second push stage.

3. The circuit of claim 2, wherein:
- the first path comprises a first one (21) of the CMOS inverter stages;
- the second path comprises a second one (11) and a third one (22) of the CMOS inverter stages;
- the third path comprises the second one and a fourth one (13) of the CMOS inverter stages;
- the fourth path comprises a fifth one (12) of the CMOS inverter stages.

4. The circuit of claim 3, wherein the third and fifth ones of the CMOS inverter stages have a respective stage output coupled to a base of the second (B3) and fourth (B6) bipolar transistor, respectively, via a base-emitter path of a fifth (B2) and a sixth (B5) bipolar transistor, respectively.

5. The circuit of claim 4, wherein the third and fifth ones of the CMOS inverter stages have a stage supply node coupled to the supply voltage node (Vcc) via a conduction channel of a first and a second FET (P4; P7), respectively, the first FET being turned on in response to the first output carrying a relatively high voltage and being turned off in response to the first output carrying a relatively low voltage, and the second FET being turned on in response to the second output carrying a relatively high voltage and being turned off in response to the second output carrying a relatively low voltage.

6. The circuit of claim 4 or 5, wherein the third and fifth logic stages have their respective stage output coupled to the first and second outputs, respectively, via a respective diode means (D1, S1; D2, S2).

7. The circuit of claim 3, wherein:
- the third one (P3/N3) of the CMOS inverter stages has a stage supply node connected to the first output (Q');
- the fifth one (P6/N6) of the CMOS inverter stages has a stage supply node connected to the second output (Q);
- a first switch (N4') is arranged between the base of the second bipolar transistor (Q2) and the first output for under control of the second one (11) of the CMOS inverter stages connecting the base to the first output when the second bipolar transistor is turned on;
- a second switch is arranged between the base of the fourth bipolar transistor (Q4) and the second output for under control of the fifth one of the CMOS inverter stages connecting the base to the second output when the fourth transistor is turned on.

8. The circuit of claim 1, wherein each CMOS inverter stage compnses an inverter, the inverters being sized so as to substantially equalize the propagation delays.

## Patentansprüche

1. Elektronische Schaltung, welche eine BiCMOS-Treiberschaltung aufweist mit:
- einem Eingang (D) zum Empfang eines Eingangsignals;
- einem ersten und zweiten Ausgang (Q', Q), um komplementäre Ausgangssignale als Reaktion auf das Eingangsignal vorzusehen;
- einer ersten und zweiten, bipolaren Gegentaktstufe (B1, B3; B4, B6), welche den ersten bzw. zweiten Ausgang steuert;
- mehreren CMOS-Inverterstufen (11, 12, 13, 21, 22), welche auf einer großen Anzahl Signalwegen (10, 20, 30) vom Eingang zu den Gegentaktstufen zur Steuerung derselben angeordnet sind, dadurch gekennzeichnet, daß die CMOS-Inverterstufen aufeinander ausgelegt sind, um Schaltverzögerungen auf den Signalwegen im wesentlichen auszugleichen.

2. Schaltung nach Anspruch 1, bei welcher
- die erste Gegentaktstufe aufweist:
- eine erste Push-Stufe mit einem ersten Bipolartransistor (B1; Q1) sowie eine erste Pull-Stufe mit einem zweiten Bipolartransistor (B3; Q2), wobei der erste und zweite Bipolartransistor ihre jeweiligen Kollektor-Emitter-Bahnen aufweisen, welche über den ersten Ausgang (Q') verbunden und zwischen einem Versorgungsspannungsknoten (Vcc) und Erde in Reihe angeordnet sind;
- eine zweite Push-Stufe mit einem dritten Bipolartransistor (B4;Q3) sowie eine zweite Pull-Stufe mit einem vierten Bipolartransistor (B6;Q4), wobei der dritte und vierte Bipolartransistor ihre jeweiligen Kollektor-Emitterbahnen aufweisen, welche über den zweiten Ausgang (Q) verbunden und zwischen dem Versorgungsspannungsknoten und Erde in Reihe angeordnet sind;
- die große Anzahl Signalwege aufweist:
- einen ersten Weg (20) zu der ersten Push-Stufe;
- einen zweiten Weg (30) zu der ersten Pull-Stufe;
- einen dritten Weg (30) zu der zweiten Push-Stufe;
- einen vierten Weg (10) zu der zweiten Push-Stufe.

3. Schaltung nach Anspruch 2, bei welcher
- der erste Weg eine erste (21) CMOS-Inverterstufe aufweist;
- der zweite Weg eine zweite (11) und eine dritte (22) CMOS-Inverterstufe aufweist;
- der dritte Weg die zweite und eine vierte (13) CMOS-Inverterstufe aufweist;
- der vierte Weg eine fünfte (12) CMOS-Inverterstufe aufweist.

4. Schaltung nach Anspruch 3, bei welcher die dritte und fünfte CMOS-Inverterstufen einen jeweiligen Stufenausgang aufweisen, welcher mit einer Basis des zweiten (B3) bzw. vierten (B6) Bipolartransistors über eine Basis-Emitterbahn eines fünften (B2) bzw. eines sechsten (B5) Bipolartransistors gekoppelt ist.

5. Schaltung nach Anspruch 4, bei welcher die dritte und fünfte CMOS-Inverterstufen einen Stufenversorgungsknoten aufweisen, welcher mit dem Versorgungsspannungsknoten (Vcc) über einen Leitungskanal eines ersten bzw. eines zweiten FETs (P4;P7) gekoppelt ist, wobei der erste FET als Reaktion auf den eine relativ hohe Spannung tragenden, ersten Ausgang eingeschaltet und als Reaktion auf den eine relativ niedrige Spannung tragenden, ersten Ausgang ausgeschaltet wird, und wobei der zweite FET als Reaktion auf den eine relativ hohe Spannung tragenden, zweiten Ausgang eingeschaltet und als Reaktion auf den eine relativ niedrige Spannungen tragenden, zweiten Ausgang ausgeschaltet wird.

6. Schaltung nach Anspruch 4 oder 5, bei welcher die dritte und fünfte Logikstufe ihren jeweiligen Stufenausgang über eine jeweilige Diode (D1, S1; D2, S2) mit dem ersten bzw. zweiten Ausgang gekoppelt haben.

7. Schaltung nach Anspruch 3, bei welcher:
- die dritte (P3/N3) CMOS-Inverterstufe einen mit dem ersten Ausgang (Q') verbundenen Stufenversorgungsknoten aufweist;
- die fünfte (P6/N6) CMOS-Inverterstufe einen mit dem zweiten Ausgang (Q) verbundenen Stufenversorgungsknoten aufweist;
- ein erster Schalter (N4') zwischen der Basis des zweiten Bipolartransistors (Q2) und dem ersten Ausgang angeordnet ist, um, unter Steuerung der zweiten (11) CMOS-Inverterstufe, bei eingeschaltetem zweiten Bipolartransistor die Basis mit dem ersten Ausgang zu verbinden;
- ein zweiter Schalter zwischen der Basis des vierten Bipolartransistors (Q4) und dem zweiten Ausgang angeordnet ist, um, unter Steuerung der fünften CMOS-Inverterstufe, bei eingeschaltetem vierten Transistor die Basis mit dem zweiten Ausgang zu verbinden.

8. Schaltung nach Anspruch 1, bei welcher jede CMOS-Inverterstufe einen Inverter aufweist, wobei die Inverter so bemessen sind, daß sie die Schaltverzögerungen im wesentlichen ausgleichen.

## Revendications

1. Circuit électronique comprenant un circuit d'attaque BiCMOS qui comporte :
- une entrée (D) pour recevoir un signal d'entrée;
- des première et deuxième sorties (Q', Q) pour délivrer des signaux de sortie complémentaires en réaction au signal d'entrée;
- des premier et deuxième étages push-pull bipolaires (B1, B3; B4, B6) attaquant les première et deuxième sorties, respectivement;
- une pluralité d'étages inverseurs CMOS (11, 12, 13, 21, 22) disposés dans une multitude de trajets de signal (10, 20, 30) allant de l'entrée jusqu'aux étages push-pull afin de commander les étages push-pull,
caractérisé en ce que les étages inverseurs CMOS (11, 12, 13, 21, 22) sont dimensionnés l'un par rapport à l'autre de manière à égaliser sensiblement les temps de propagation dans les trajets de signal.

2. Circuit suivant la revendication 1, dans lequel :
- le premier étage push-pull comprend :
- un premier étage push avec un premier transistor bipolaire (B1; Q1) et un premier étage pull avec un deuxième transistor bipolaire (B3; Q2), le premier et le deuxième transistors bipolaires ayant leurs trajets collecteur-émetteur respectifs interconnectés via la première sortie (Q') et montés en série entre un noeud de tension d'alimentation (Vcc) et la masse;
- le deuxième étage push-pull comprend :
- un deuxième étage push avec un troisième transistor bipolaire (B4; Q3) et un deuxième étage pull avec un quatrième transistor bipolaire (B6; Q4), le troisième et le quatrième transistors bipolaires ayant leurs trajets collecteur-émetteur respectifs interconnectés via la deuxième sortie (Q) et montés en série entre le noeud de tension d'alimentation et la masse;
- la multitude de trajets de signal comprend :
- un premier trajet (20) allant jusqu'au premier étage push;
- un deuxième trajet (30) allant jusqu'au premier étage pull;
- un troisième trajet (30) allant jusqu'au deuxième étage push;
- un quatrième trajet (10) allant jusqu'au deuxième étage push.

3. Circuit suivant la revendication 2, dans lequel :
- le premier trajet comprend un premier étage (21) des étages inverseurs CMOS;
- le deuxième trajet comprend un deuxième étage (11) et un troisième étage (22) des étages inverseurs CMOS;
- le troisième trajet comprend le deuxième étage et un quatrième étage (13) des étages inverseurs CMOS;
- le quatrième étage comprend un cinquième étage (12) des étages inverseurs CMOS.

4. Circuit suivant la revendication 3, dans lequel le troisième et le cinquième étages des étages inverseurs CMOS ont une sortie d'étage respective couplée à une base des deuxième (B3) et quatrième (B6) transistors bipolaires, respectivement, via un trajet base-émetteur d'un cinquième (B2) et d'un sixième (B5) transistors bipolaires, respectivement.

5. Circuit suivant la revendication 4, dans lequel les troisième et cinquième étages des étages inverseurs CMOS ont un noeud d'alimentation d'étage couplé au noeud de tension d'alimentation (Vcc) via un canal de conduction d'un premier et d'un deuxième FET (P4; P7), respectivement, le premier FET étant rendu passant en réaction à la première sortie acheminant une tension relativement élevée et étant rendu bloquant en réaction à la première sortie acheminant une tension relativement basse, et le deuxième FET étant rendu passant en réaction à la deuxième sortie acheminant une tension relativement élevée et étant rendu bloquant en réaction à la deuxième sortie acheminant une tension relativement basse.

6. Circuit suivant la revendication 4 ou 5, dans lequel les troisième et cinquième étages logiques ont leurs sorties d'étage respectives couplées aux première et deuxième sorties, respectivement, via un moyen à diodes respectif (D1, S1; D2, S2).

7. Circuit suivant la revendication 3, dans lequel :
- le troisième étage inverseur CMOS (P3/N3) a un noeud d'alimentation d'étage connecté à la première sortie (Q');
- le cinquième étage inverseur CMOS (P6/N6) a un noeud d'alimentation d'étage connecté à la deuxième sortie (Q);
- un premier commutateur (N4') est disposé entre la base du deuxième transistor bipolaire (Q2) et la première sortie afin de connecter, sous la commande du deuxième étage inverseur CMOS (11), la base à la première sortie lorsque le deuxième transistor bipolaire est rendu conducteur;
- un deuxième commutateur est monté entre la base du quatrième transistor bipolaire (Q4) et la deuxième sortie pour, sous la commande du cinquième étage inverseur CMOS, connecter la base à la deuxième sortie lorsque le quatrième transistor est rendu conducteur.

8. Circuit suivant la revendication 1, dans lequel chaque étage inverseur CMOS comprend un inverseur, les inverseurs étant dimensionnés de manière à égaliser sensiblement les temps de propagation.
